# FASCICULE DE BREVET EUROPEEN

(11) **EP 3 253 620 B1**
(45) Date de publication et mention de la délivrance du brevet: **30.08.2023**
(21) Numéro de dépôt: 16706985.5
(22) Date de dépôt: 05.02.2016
(51) Int. Cl.: F21S 41/19, H05K 1/02, H05K 1/11, B60Q 1/00, H01L 33/62, F21V 23/00, H01R 43/16, H05K 3/20, H01L 33/48

(54) **DISPOSITIF DE CONNEXION D'UNE SOURCE LUMINEUSE À UN DISPOSITIF D'ALIMENTATION ÉLECTRIQUE**
VORRICHTUNG ZUM ANSCHLIESSEN EINER LICHTQUELLE AN EINER ELEKTRISCHEN STROMVERSORGUNGSVORRICHTUNG
DEVICE FOR CONNECTING A LIGHT SOURCE TO AN ELECTRICAL POWER SUPPLY DEVICE

(30) Priorité: 05.02.2015 FR 1550887
(43) Date de publication de la demande: 13.12.2017
(73) Titulaire: Valeo Vision, 93012 Bobigny Cedex (FR)
(72) Inventeur: ZOJCESKI, Zdravko, 93012 Bobigny Cedex (FR); DUARTE, Marc, 93012 Bobigny Cedex (FR)
(74) Mandataire: Valeo Visibility
(86) Numéro de dépôt international: PCT/EP2016/052570
(87) Numéro de publication internationale: WO 2016/124776

(56) Documents cités:
- EP-A1- 1 923 626
- EP-A1- 2 306 599
- EP-A1- 2 333 407
- EP-A1- 2 623 850
- EP-A2- 1 853 096
- WO-A1-98/09486
- DE-A1-102008 000 582
- JP-A- 2011 054 473
- US-A1- 2008 117 647
- US-A1- 2008 129 204
- US-A1- 2014 218 954

## Description

L'invention a trait au domaine de l'alimentation électrique de sources lumineuses. En particulier, l'invention se rapporte à un système de connexion d'une ou de plusieurs sources lumineuses, plus précisément de diodes électroluminescentes, LED, à un dispositif d'alimentation électrique.

Des dispositifs de connexion connus sont décrits dans les documents US 2008/129204 A, JP 2011054473 et WO 98/09486 A1.

Une diode électroluminescente, LED, est un composant électronique capable d'émettre de la lumière lorsqu'il est parcouru par un courant électrique. L'intensité lumineuse émise par une LED est en général dépendante de l'intensité du courant électrique qui la traverse. Entre autres, une LED est caractérisée par une valeur seuil d'intensité de courant. Ce courant direct (« forward current ») maximal est en général décroissant à température croissante.

Il est donc important de gérer le comportement thermique de telles sources lumineuses afin d'assurer leur fonctionnement et l'émission de lumière d'une intensité constante. Ceci est particulièrement important dans le domaine des dispositifs d'éclairage et/ou de signalisation pour véhicules automobiles, dans lesquels le bon fonctionnement et l'émission de lumière à intensité constante représentent des facteurs de sécurité pour les utilisateurs du véhicule qui en est équipé. L'utilisation de LEDs est de plus en plus préconisée dans le domaine des véhicules automobiles, puisque les LEDs permettent de créer des dessins particulièrement distinctifs des feux, qui sont impossibles à réaliser avec des sources lumineuses conventionnelles.

Il est connu de connecter un montage électronique comprenant une ou plusieurs LEDs à distance à un circuit d'alimentation électrique, par exemple à l'aide d'un harnais de connecteurs électriques. Le circuit d'alimentation électrique peut de manière connue convertir une tension d'entrée, fournie par une batterie automobile, en une tension de charge apte à alimenter les sources lumineuses. La connexion à distance permet de rendre la gestion de l'espace d'installation des sources lumineuses plus flexible, ce qui est particulièrement important pour l'installation de LEDs dans l'espace restreint d'un feu d'un véhicule automobile.

De même, il a été proposé de déporter un sous-montage comprenant la ou les sources lumineuses physiquement du montage électronique qui sert à la connexion du dispositif d'alimentation électrique, et qui est typiquement logé dans un châssis. Un tel arrangement permet d'éviter que le montage électronique ne doive supporter la chaleur importante produite par les sources lumineuses, notamment lorsqu'il s'agit de LEDs de puissance. Un tel dispositif de connexion connu comprend néanmoins des moyens propres de dissipation thermique afin d'évacuer la chaleur produite par le circuit électronique lui-même. Ces moyens comprennent typiquement des éléments physiquement volumineux, tels que des circuits résistifs. Ces éléments risquent de porter ombre sur les LEDs, ce qui impose une contrainte géométrique de placement du sous-montage comprenant les LEDs par rapport au montage de connexion. Le dimensionnement approprié de tels circuits résistifs doit en plus être adapté à chaque application spécifique visée, ce qui rend la production en masse problématique. Des montages électroniques de connexion connus nécessitent un connecteur électrique dédié qui permet leur connexion à un dispositif d'alimentation électrique. De tels connecteurs électriques nécessitent une prise dédiée de format standardisé. La hauteur du châssis logeant le montage électronique est donc au moins égale à la hauteur d'un logement d'une telle prise, ce qui augmente le risque d'ombre portée par le châssis sur les LEDs y reliées.

L'invention a pour objectif de proposer un dispositif de connexion qui pallie au moins un des inconvénients présents dans l'état de l'art. L'invention a également pour objectif de proposer un dispositif lumineux utilisant un tel dispositif de connexion, ainsi qu'un dispositif d'éclairage et/ou de signalisation pour un véhicule automobile, utilisant un tel dispositif lumineux.

L'invention a pour objet un dispositif de connexion électrique d'au moins une source lumineuse à un dispositif d'alimentation électrique tel que défini dans la revendication 1. Le dispositif de connexion comprend une grille de connexion et des premiers moyens de connexion destinés à connecter par pontage la grille à une source lumineuse à distance de la grille. Le dispositif de connexion est remarquable en ce qu'il comprend en outre des deuxièmes moyens de connexion destinés à connecter par sertissage la grille à un dispositif d'alimentation électrique.

Le dispositif peut de préférence comprendre des moyens de connexion mécaniques destinés à relier le dispositif à des moyens de dissipation de chaleur.

Les moyens de connexion mécaniques peuvent préférentiellement faire saillie sur une première surface d'un élément de support, la grille de connexion étant logée sur une deuxième surface de l'élément de support, située du côté opposé de la première surface. La géométrie de l'élément de support peut être généralement plane.

Les moyens de connexion mécaniques peuvent de préférence comprendre un matériau conducteur thermique. Les moyens de connexion peuvent avantageusement comprendre un ou plusieurs bras qui s'étendent de manière orthogonale à partir de la première surface, pour former des pattes à leur extrémité. Chaque patte peut comprendre un élément de clippage qui est apte à s'engager dans une structure correspondante des moyens de dissipation de chaleur. Les moyens de dissipation de chaleur peuvent par exemple comprendre un radiateur ayant des lamelles de refroidissement, avec lesquelles l'élément de clippage peut coopérer.

Les deuxièmes moyens de connexion du dispositif de connexion comprennent, selon l'invention, au moins une cosse électriquement conductrice et destinée à être sertie à un élément de connexion d'un dispositif d'alimentation électrique.

Les deuxièmes moyens de connexion comprennent, selon l'invention, un alignement d'une pluralité de cosses électriquement conductrices et séparées par des éléments électriquement isolants.

Les premiers moyens de connexion peuvent de préférence comprendre au moins une languette de connexion et au moins un fil de pontage. Le fil de pontage peut avantageusement être relié à la languette de connexion par soudage.

La grille de connexion du dispositif de connexion peut préférentiellement comprendre un circuit électrique. Un tel circuit peut comprendre un moyen de protection contre des décharges électrostatiques (ESD) comme une capacité, un moyen de mesure de la température comme une thermistance, et une résistance de bin agencée pour permettre au dispositif d'alimentation électrique à s'adapter à la caractéristique flux lumineux versus courant de chaque LED connectée par le biais des premiers moyens de connexion.

L'invention a également pour objet un dispositif lumineux pour un véhicule automobile comprenant des moyens d'alimentation électrique connectés à l'aide d'un élément de connexion électrique à au moins une source lumineuse à distance de l'élément de connexion. Le dispositif lumineux est remarquable en ce que l'élément de connexion est conforme au dispositif de connexion selon la présente invention. Les moyens d'alimentation électrique sont préférentiellement reliés au dispositif de connexion à l'aide d'un harnais ou faisceau d'alimentation électrique du véhicule automobile. Le dispositif de connexion est ainsi avantageusement dépourvu d'un connecteur supplémentaire entre le faisceau d'alimentation et le dispositif de connexion d'une part, et entre le dispositif de connexion et les sources lumineuses d'autre part.

De préférence, la source lumineuse peut être une diode électroluminescente, LED.

L'invention a également pour objet un dispositif d'éclairage et/ou de signalisation pour un véhicule automobile. Le dispositif d'éclairage et/ou de signalisation est remarquable en ce qu'il comprend un dispositif lumineux conforme à la présente invention.

Le dispositif selon l'invention permet de connecter une ou plusieurs sources lumineuses, notamment des diodes électroluminescentes, LED, à une alimentation électrique. Le dispositif de connexion permet une connexion à distance des sources lumineuses d'une part, et du dispositif d'alimentation d'autre part. Les mesures de l'invention permettent au dispositif de connexion de présenter des dimensions réduites par rapport à des dispositifs de connexion connus de l'art antérieur. Comme la connexion à un dispositif d'alimentation électrique se fait par sertissage, les dimensions du dispositif de connexion sont réduites par rapport à un dispositif nécessitant un logement pour une prise d'un connecteur standard. Cette réduction permet le placement du sous-montage comprenant les LEDs, réalisé par pontage (en anglais « wire-bonding »), à proximité du dispositif de connexion. Ceci n'est pas possible en utilisant des dispositifs de connexion connus, puisque leur hauteur par rapport à la hauteur du sous-montage des LEDs implique que les dispositifs connus portent ombre sur les LEDs et limitent donc leur utilité. Les moyens mécaniques aptes à connecter le dispositif de connexion à un radiateur permettent de s'affranchir d'un circuit résistif sur la grille de connexion. L'absence d'un circuit résistif sur la grille de connexion du dispositif permet d'une part une réduction des dimensions du dispositif, aidant ainsi à réduire l'effet d'ombre portée décrit cidessus, et d'autre part elle permet la production en masse du connecteur selon l'invention, qui peut être utilisé dans des applications diverses.

D'autres caractéristiques et avantages de la présente invention seront mieux compris à l'aide de la description des réalisations exemplaires de l'invention et des dessins parmi lesquels :
- la figure 1 est une illustration en perspective d'un mode de réalisation préférentiel du dispositif selon l'invention ;
- la figure 2 est une illustration en coupe latérale d'un mode de réalisation préférentiel du dispositif selon l'invention ;
- la figure 3 est une illustration en vue de dessus d'un mode de réalisation préférentiel du dispositif selon l'invention.

Dans la description qui va suivre, les termes qualifiant la position et les dimensions de certains éléments, tels que « sur », « en-dessous », « hauteur » etc. se réfèrent aux agencements spécifiques des figures. Ces termes ne doivent cependant pas être interprétés de manière stricte et absolue mais bien relative. En effet, les dispositifs qui y sont décrits peuvent être en pratique orientés différemment sans s'éloigner aucunement de l'invention.

Sauf indication explicite du contraire, les caractéristiques techniques décrites pour un mode de réalisation donné de l'invention peuvent être combinés à des caractéristiques techniques décrites pour d'autres modes de réalisation, sans pour autant s'éloigner de l'invention. La séparation de telles caractéristiques est opérée afin d'améliorer la clarté de l'exposé uniquement.

Des numéros de référence similaires sont utilisés pour décrire des caractéristiques similaires de l'invention dans des modes de réalisation distincts. Par exemple, les numéros 100 et 200 sont utilisés pour décrire le dispositif de connexion électrique selon l'invention dans deux modes de réalisation distincts.

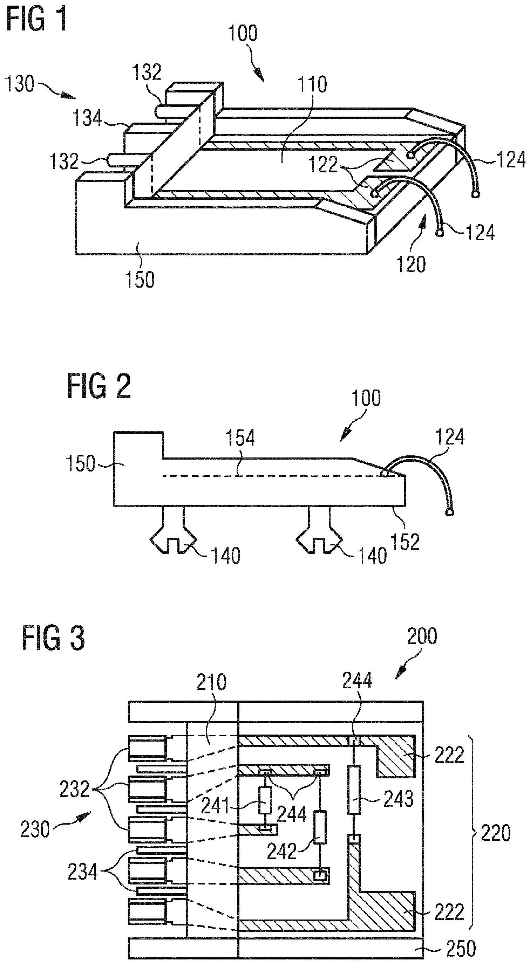

La figure 1 montre une illustration d'un mode de réalisation préférentiel du dispositif de connexion selon l'invention. Le dispositif 100 comprend une grille de connexion 110. Une grille de connexion est une structure de pistes conductrices réalisée d'un seul tenant. Cette grille de connexion, appelée « leadframe » en anglais, peut par exemple être une tôle estampée pour former des pistes électriques, puis surmoulée à un substrat isolant et dont les parties autres que celles formant les pistes sont séparées de la tôle après surmoulage. Des premiers moyens de connexion 120 sont aptes à connecter la grille 110 à un sous-montage comprenant une ou plusieurs sources lumineuses. A titre exemplaire mais non limitatif, les sources lumineuses sont considérées être des diodes luminescentes, LED, dans ce qui suit. Les premiers moyens de connexion 120 comprennent une languette de connexion 122 (en anglais « pad ») apte à permettre la connexion à la LED en appliquant la technique de la soudure de fil 124 (anglais « wirebonding »). Cette connexion est réalisée par pontage. Des techniques de pontage sont en soi bien connues dans l'état de l'art. De cette manière, les LEDs sont connectées électriquement à la grille de connexion 110 tout en étant déportées et éloignées par rapport à cette dernière, ce qui permet avantageusement de simplifier la structure de la grille de connexion. Le dispositif 100 comprend également des deuxièmes moyens de connexion 130 destinés à connecter par sertissage la grille de connexion 110 à un dispositif d'alimentation électrique. A cet effet, les moyens de connexion 130 comprennent des cosses 132 électriquement conductrices, permettant de sertir une première extrémité des fils conducteurs d'un harnais de connexion, dont la deuxième extrémité est reliée à un dispositif d'alimentation électrique en soi connu dans l'art. Des outils pour réaliser cette connexion par cosses serties sont en soi connus dans l'art et ne vont pas être détaillés plus amplement dans le contexte de la présente invention. L'utilisation des cosses 132 permet de réduire l'espace prévu pour les moyens de connexion sur le dispositif 100. Spécifiquement, le dispositif 100, avec référence à la figure 1 peut présenter une hauteur relativement faible grâce à cette mesure. Ceci présente l'avantage qu'un sous-montage relié par les moyens de connexion 120 ne subit pas ou que peu d'ombre portée de la part du dispositif 100.

La grille 110 est logée sur un support 150, qui peut dans un mode de réalisation préféré former un châssis du dispositif 100, tel qu'il est illustré sur la figure 1. Le châssis illustré définit une surface essentiellement plane sur laquelle la grille 110 est logée. Il comporte également des murs longeant les côtés de la surface. La surface est montrée comme étant rectangulaire, mais elle peut également présenter une géométrie différente sans pour autant sortir du cadre de l'invention. De même les premiers 120 et deuxièmes 130 moyens de connexion sont illustrés comme étant logés à des extrémités opposées de la surface du support 150, bien que d'autres dispositions sont envisageables sans sortir du cadre de l'invention. Le châssis ou élément de support 150 peut de préférence être produit par moulage d'une matière synthétique, comme par exemple du polypropylène, PP. Avantageusement, l'élément de support comprend un ou plusieurs éléments séparateurs 134 électriquement isolants qui permettent de séparer les cosses 132 afin de faciliter l'opération de sertissage. Comme indiqué sur la figure 1, les éléments séparateurs 134 peuvent par exemple être formés par des murs perpendiculaires au plan de la grille de connexion 110 et s'élevant entre les cosses 132. D'autres géométries seront à la portée de l'homme du métier, qui saura adapter la configuration décrite aux contraintes d'applications spécifiques.

En plus de la configuration montrée par la figure 1, la grille de connexion peut comprendre un montage électronique comprenant des résistances des capacités, des thermisteurs ou d'autres éléments, dépendant de la fonctionnalité implémentée par le montage. Les éléments du montage sont idéalement fixés par la technique du soudage laser.

La figure 2 montre une coupe latérale du dispositif 100. On y aperçoit l'élément de support 150 qui définit deux surfaces planes opposées 152 et 154. La grille 110 est logée sur la surface 154. La surface 152 comprend des moyens de connexion qui permettent de relier le dispositif 100 à un dispositif de dissipation thermique, tel qu'un radiateur disposé en-dessous du dispositif 100, qui permet d'évacuer la chaleur produite par le dispositif 100. Dans le mode de réalisation illustré, les moyens de connexion 140 comprennent des bras qui s'étendent de façon perpendiculaire à la surface 152. Les extrémités de bras sont pourvues d'éléments de clippage ou griffes qui permettent de s'engager par exemple entre des lamelles de refroidissement d'un dispositif radiateur. Les bras 140 sont de préférence produits dans une matière thermiquement conductrice et reliés à la grille 110. Ceci est réalisé par exemple par des trous dans le plan défini par l'élément 150, aptes à conduire la chaleur produite par la grille 110 vers les bras 140 pour être dissipée par un dispositif radiateur. La géométrie exacte des griffes peut varier sans pour autant sortir du cadre de l'invention. L'homme du métier saura adapter les moyens de connexion 140 de façon à ce qu'ils puissent coopérer avec des dispositifs de dissipation spécifiques en soi connus dans l'art.

Alternativement, la surface 152 peut comprendre des liaisons thermiques vers la grille 110 au niveau de la surface elle-même. Une couche de colle thermiquement conductrice peut alors être utilisée pour connecter la surface 152 à un élément de dissipation thermique ayant une surface de liaison essentiellement plane.

Les mesures décrites permettent de s'affranchir d'un circuit résistif sur la grille de connexion 110, tel qu'il est utilisé de coutume dans les dispositifs connus de l'art antérieur, et qui aurait pour seul but la dissipation de la chaleur produite par la grille. Les éléments de tels circuits sont généralement volumineux et augmentent les dimensions géométriques du dispositif 100. L'utilisation des moyens de connexion et de dissipation thermique 140 permet donc de réduire les dimensions du dispositif davantage tout en garantissant la dissipation thermique nécessaire au bon fonctionnement de la grille de connexion 110. La réduction des dimensions réduit davantage le risque d'ombre portée sur un sous-montage connecté au dispositif et comprenant des LEDs.

La figure 3 montre de manière schématique une vue de dessus d'un mode de réalisation préférentiel 200 du dispositif 200 selon l'invention. Le dispositif 200 est largement similaire au dispositif 100 décrit préalablement et comprend une grille de connexion 210 similaire à celle décrite pour les modes de réalisations précédents. Des premiers moyens de connexion 220 sont aptes à connecter la grille 210 à un sous-montage comprenant une ou plusieurs sources lumineuses. Les premiers moyens de connexion 220 comprennent une languette de connexion 222 (en anglais « pad ») apte à permettre la connexion à la LED en appliquant la technique de la soudure de fil. Cette connexion est réalisée par pontage. Le dispositif 200 comprend également des deuxièmes moyens de connexion 230 destinés à connecter par sertissage la grille de connexion 210 à un dispositif d'alimentation électrique. A cet effet, les moyens de connexion 230 comprennent des cosses 232 électriquement conductrices, permettant de sertir une première extrémité des fils conducteurs d'un harnais de connexion, dont la deuxième extrémité est reliée à un dispositif d'alimentation électrique en soi connu dans l'art.

La grille 210 peut avantageusement être logée sur un support 250, qui peut dans un mode de réalisation préféré former un châssis du dispositif 200. Avantageusement, l'élément de support comprend un ou plusieurs éléments séparateurs 234 électriquement isolants qui permettent de séparer les cosses 232 afin de faciliter l'opération de sertissage. Comme indiqué sur la figure 3, les éléments séparateurs 234 peuvent par exemple être formés par des murs perpendiculaires au plan de la grille de connexion 210 et s'élevant entre les cosses 232.

Comme illustré sur la figure 3, la grille de connexion peut avantageusement comprendre un montage électronique comprenant des résistances des capacités, des thermisteurs ou d'autres éléments, dépendant de la fonctionnalité implémentée par le montage. Le montage illustré comprend un moyen de protection contre des décharges électrostatiques, ESD, réalisé par exemple par une capacité 243. Il peut également comprendre un moyen de mesure de la température, comme par exemple une thermistance 242, et un résistance de bin 241 agencé de façon à permettre au dispositif d'alimentation électrique connecté par sertissage à s'adapter à la caractéristique flux lumineux versus courant de chacune des LEDs connectées par le biais des premiers moyens de connexion 220. Les éléments du montage sont idéalement fixés par des soudures laser 244.

Les mesures de l'invention rendent le connecteur particulièrement utile dans la construction d'un dispositif lumineux pour un véhicule automobile. Les feux présentent des espaces réduits. Le dispositif de connexion selon l'invention présente des dimensions réduites par rapport à des dispositifs de connexion connus de l'art antérieur, ce qui est un avantage en soi dans ce contexte. En plus, comme le dispositif selon l'invention réduit le risque de porter ombre sur un sous-montage comprenant des sources lumineuses, il assure une plus grande liberté de placement des sources lumineuses dans un tel dispositif lumineux, en s'affranchissant de certaines contraintes de placement connues dans l'état de l'art. En particulier, un dispositif lumineux utilisant le dispositif de connexion selon l'invention trouve son application dans un dispositif d'éclairage et/ou de signalisation d'un véhicule automobile.

## Revendications

1. Dispositif de connexion électrique (100) d'au moins une source lumineuse à
un dispositif d'alimentation électrique, le dispositif de connexion comprenant
une grille de connexion (110), des premiers moyens de connexion (120) destinés à connecter par pontage la grille (110) à une source lumineuse à distance de la grille, la grille de connexion (110) étant logée sur un support (150) qui forme un châssis du dispositif (100) définissant une surface essentiellement plane sur laquelle la grille (110) est logée,
et **caractérisé en ce que** le dispositif de connexion (100) comprend en outre des deuxièmes moyens de connexion (130) destinés à connecter par sertissage la grille (110) à un dispositif d'alimentation électrique, les deuxièmes moyens de connexion (130) comprenant au moins une cosse (132) électriquement conductrice et destinée à être sertie à un élément de connexion d'un dispositif d'alimentation électrique, les deuxièmes moyens de connexion (130) comprenant un alignement d'une pluralité de cosses (132) électriquement conductrices et séparées par un ou des éléments électriquement isolants (134).

2. Dispositif selon la revendication 1, **caractérisé en ce que** le dispositif (100) comprend des moyens de connexion mécaniques (140) destinés à relier le dispositif à des moyens de dissipation de chaleur.

3. Dispositif selon la revendication 2, caractérisé en que les moyens de connexion mécaniques (140) font saillie sur une première surface (152) de l'élément de support (150), la grille de connexion (110) étant logée sur une deuxième surface (154) de l'élément de support (150), située du côté opposé de la première surface (152).

4. Dispositif selon une des revendications 2 ou 3, **caractérisé en ce que** les moyens de connexion mécaniques (140) comprennent un matériau conducteur thermique.

5. Dispositif selon une des revendications 1 à 4, **caractérisé en ce que** les premiers moyens de connexion (120) comprennent au moins une languette (122) de connexion et au moins un fil de pontage (124).

6. Dispositif selon la revendication 5, caractérisé en que le fil de pontage (124) est relié à la languette de connexion (122) par soudage.

7. Dispositif selon une des revendications 1 à 6, **caractérisé en ce que** la grille de connexion (110) comprend un circuit électrique.

8. Dispositif lumineux pour un véhicule automobile comprenant des moyens d'alimentation électrique connectés à l'aide d'un élément de connexion électrique (100) à au moins une source lumineuse à distance de l'élément de connexion, **caractérisé en ce que** l'élément de connexion (100) est conforme au dispositif selon une des revendications 1 à 7.

9. Dispositif selon la revendication 8, caractérisé en que la source lumineuse est une diode électroluminescente, LED.

10. Dispositif d'éclairage et/ou de signalisation pour un véhicule automobile, **caractérisé en ce qu'**il comprend un dispositif lumineux selon une des revendications 8 ou 9.

## Patentansprüche

1. Elektrische Anschlussvorrichtung (100) zum Anschließen mindestens einer Lichtquelle an eine elektrische Versorgungsvorrichtung, wobei die Anschlussvorrichtung einen Anschlussrahmen (110) umfasst, erste Anschlussmittel (120), die dazu bestimmt sind, den Rahmen (110) durch Überbrücken an eine von dem Rahmen entfernte Lichtquelle anzuschließen, wobei der Anschlussrahmen (110) auf einem Träger (150) aufgenommen ist, der ein Gestell der Vorrichtung (100) bildet, das eine im Wesentlichen plane Fläche definiert, auf welcher der Rahmen (110) aufgenommen ist, und **dadurch gekennzeichnet, dass** die Anschlussvorrichtung (100) ferner zweite Anschlussmittel (130) umfasst, die dazu bestimmt sind, den Rahmen (110) durch Crimpen an eine elektrische Versorgungsvorrichtung anzuschließen, wobei die zweiten Anschlussmittel (130) mindestens eine Hülse (132) umfassen, die elektrisch leitend ist und dazu bestimmt ist, an ein Anschlusselement einer elektrischen Versorgungsvorrichtung gecrimpt zu werden, wobei die zweiten Anschlussmittel (130) eine Aneinanderreihung einer Mehrzahl von Hülsen (132) umfassen, die elektrisch leitend sind und voneinander durch ein oder mehrere elektrisch isolierende Elemente (134) getrennt sind.

2. Vorrichtung nach Anspruch 1, **dadurch gekennzeichnet, dass** die Vorrichtung (100) mechanische Anschlussmittel (140) umfasst, die dazu bestimmt sind, die Vorrichtung mit Wärmeableitungsmitteln zu verbinden.

3. Vorrichtung nach Anspruch 2, **dadurch gekennzeichnet, dass** die mechanischen Anschlussmittel (140) über eine erste Fläche (152) des Trägerelements (150) hinausragen, wobei der Anschlussrahmen (110) auf einer zweiten Fläche (154) des Trägerelements (150) aufgenommen ist, die auf der zur ersten Fläche (152) entgegengesetzten Seite gelegen ist.

4. Vorrichtung nach einem der Ansprüche 2 oder 3, **dadurch gekennzeichnet, dass** die mechanischen Anschlussmittel (140) ein thermisch leitendes Material umfassen.

5. Vorrichtung nach einem der Ansprüche 1 bis 4, **dadurch gekennzeichnet, dass** die ersten Anschlussmittel (120) mindestens eine Anschlusszunge (122) und mindestens einen Überbrückungsdraht (124) umfassen.

6. Vorrichtung nach Anspruch 5, **dadurch gekennzeichnet, dass** der Überbrückungsdraht (124) mit der Anschlusszunge (122) durch Schweißen verbunden ist.

7. Vorrichtung nach einem der Ansprüche 1 bis 6, **dadurch gekennzeichnet, dass** der Anschlussrahmen (110) eine elektrische Schaltung umfasst.

8. Leuchtvorrichtung für ein Kraftfahrzeug, umfassend elektrische Versorgungsmittel, die mithilfe eines elektrischen Anschlusselements (100) an mindestens eine von dem Anschlusselement entfernte Lichtquelle angeschlossen sind, **dadurch gekennzeichnet, dass** das Anschlusselement (100) der Vorrichtung nach einem der Ansprüche 1 bis 7 entspricht.

9. Vorrichtung nach Anspruch 8, gekennzeichnet, dass die Lichtquelle eine Leuchtdiode, LED, ist.

10. Beleuchtungs- und/oder Signalisierungsvorrichtung für ein Kraftfahrzeug, **dadurch gekennzeichnet, dass** sie eine Vorrichtung nach einem der Ansprüche 8 oder 9 umfasst.

## Claims

1. Device (100) for the electrical connection of at least one light source to an electric power supply device, the connecting device comprising a lead frame (110), first connecting means (120) which are designed for the connection of the frame (110), by bridging, to a light source which is remote from the frame, the lead frame (110) being accommodated on a support (150) which forms a rack of the device (100), defining an essentially planar surface, upon which the frame (110) is accommodated, and **characterized in that** the connecting device (100) moreover comprises second connecting means (130) which are designed to connect the frame (110), by crimping, to an electric power supply device, the second connecting means (130) comprising at least one electrically-conductive lug (132) designed to be crimped to a connecting element of an electric power supply device, the second connecting means (130) comprising a row of a plurality of electrically conductive lugs (132), separated by one or more electrically insulating elements (134) .

2. Device according to Claim 1, **characterized in that** the device (100) comprises mechanical connecting means (140), which are designed to connect the device to heat dissipation means.

3. Device according to Claim 2, **characterized in that** the mechanical connecting means (140) project from a first surface (152) of the support element (150), the lead frame (110) being accommodated on a second surface (154) of the support element (150), which is situated on the opposite side to the first surface (152).

4. Device according to one of Claims 2 and 3, **characterized in that** the mechanical connecting means (140) comprise a thermally conductive material.

5. Device according to one of Claims 1 to 4, **characterized in that** the first connecting means (120) comprise at least one connecting pad (122) and at least one bridging wire (124).

6. Device according to Claim 5, **characterized in that** the bridging wire (124) is connected to the connecting pad (122) by welding.

7. Device according to one of Claims 1 to 6, **characterized in that** the lead frame (110) comprises an electric circuit.

8. Luminous device for a motor vehicle comprising electric power supply means which are connected by means of an electrical connecting element (100) to at least one light source which is remote from the connecting element, **characterized in that** the connecting element (100) is compliant with the device according to one of Claims 1 to 7.

9. Device according to Claim 8, **characterized in that** the light source is a light-emitting diode, or LED.

10. Lighting and/or signalling device for a motor vehicle, **characterized in that** it comprises a luminous device according to one of Claims 8 or 9.
